# EUROPÄISCHE PATENTSCHRIFT

(11) **EP 1 112 159 B1**
(45) Veröffentlichungstag und Bekanntmachung des Hinweises auf die Patenterteilung: **03.07.2002**
(21) Anmeldenummer: 99946031.4
(22) Anmeldetag: 26.08.1999
(51) Int. Cl.: B29C 45/14, H01R 43/24, H01L 23/498

(54) **VERFAHREN ZUR HERSTELLUNG EINES HYBRIDRAHMENS ODER HYBRIDGEHÄUSES SOWIE EIN DERARTIGER HYBRIDRAHMEN ODER EIN HYBRIDGEHÄUSE**
METHOD FOR PRODUCING A HYBRID FRAME OR HYBRID HOUSING AND CORRESPONDING HYBRID FRAME OR HYBRID HOUSING
PROCEDE PERMETTANT DE PRODUIRE UN CADRE HYBRIDE OU DES BOITIERS HYBRIDES ET CADRE HYBRIDE OU BOITIER HYBRIDE AINSI OBTENUS

(30) Priorität: 09.09.1998 DE 19841293; 19.09.1998 DE 19843076
(43) Veröffentlichungstag der Anmeldung: 04.07.2001
(73) Patentinhaber: AMI Doduco GmbH, 75181 Pforzheim (DE)
(72) Erfinder: ANDERL, Jörg, D-74889 Sinsheim (DE); BENDER, Herbert, D-74889 Sinsheim (DE); LÜTTE, Winfried, F-67510 Climbach (FR); VOGEL, Jürgen, D-75447 Sternenfels (DE); VOLL, Norbert, D-74912 Kirchardt (DE)
(74) Vertreter: Leitner, Waldemar, Dr. techn.
(86) Internationale Anmeldenummer: EP9906264
(87) Internationale Veröffentlichungsnummer: WO0013875

(56) Entgegenhaltungen:
- EP-A- 0 642 165
- US-A- 5 359 761
- PATENT ABSTRACTS OF JAPAN vol. 6, no. 72 (E-105), 7. Mai 1982 (1982-05-07) & JP 57 010955 A (MITSUBISHI ELECTRIC CORP), 20. Januar 1982 (1982-01-20)

## Beschreibung

Die Erfindung betrifft ein Verfahren zur Herstellung eines Hybridrahmen oder Hybridgehäuses, bei dem ein Leadframe mit Löt- und/oder Bondfahnen nach dem Einlegen in eine Spritzform in dieser Spritzform gehalten und zur Ausbildung eines Gehäuseteils des Hybridrahmens oder des Hybridgehäuses mit Kunststoff umspritzt wird, sowie ein derartiger Hybridrahmen oder ein derartiges Hybridgehäuse.

Beim Stanzen der Löt- und/oder Bondfahnen des Leadframes entsteht ein sogenannter Stanzeinzug. Dieser Stanzeinzug kann in nachteiliger Art und Weise den Verzug der gesamten Oberfläche des Leadframes mit sich ziehen, so daß keine ebene und gleichmäßige Oberfläche insbesondere der Löt- und/oder Bondfahnen gegeben ist. Die aus dem Kunststoff nach dem Umspritzen herausstehenden Lötoder Bondfahnen des Leadframes werden beim Umspritzen nicht gehalten, sondern es ist lediglich vorgesehen, daß die Spritzform derart ausgebildet ist, daß die Bondfahnen sich in der Kunststoffspritzform beim Spritzvorgang nicht verschieben können.

Ein Verfahren mit den eingangs genannten Merkmalen ist aus der JP 57 010955 bekannt. Dabei wird ein Leadframe in eine zweiteilige Gußform eingebracht Indem die beiden Teile der Gußform zusammengefügt werden, werden die Löt- und/oder Bondfahnen des Leadframes durch das Zusammenwirken von Vorsprüngen im einen Teil der Gußform und Ausnehmungen im anderen Teil gebogen. Weiterhin wird der Rahmen des Leadframes während des Spritzvorgangs durch Anpressstäbe festgehalten und lagefixiert. Das Biegen der Löt- und/oder Bondfahnen ist nicht geeignet, einen beim Stanzen des Leadframes entstehenden Stanzeinzug der Löt- und/oder Bondfahnen auszugleichen, so daß auch nach dem Umspritzen des Leadframes in nachteiliger Art und Weise keine ebene und gleichemäßige Oberfläche der Löt- und/oder Bondfahnen gegeben.

Aus der US 5,359,761 ist ein Verfahren bekannt, mit dem ein Leadframe in eine zweiteilige Gußform eingebracht und in Kunststoff eingegossen wird. Weiter ist eine Stanzeinrichtung vorgesehen, mit der ein Rahmen des Leadframes entlang einer Sollbruchstelle abgetrennt werden kann, während sich der Leadframe in der zweiteiligen Gußform befindet.

Aus der EP 0 642 165 ist ein Hybridrahmen aus Kunststoff mit elektrischen Verbindungselementen bekannt, der eine Versteifung in Form einer Prägung aufweist.

Es ist daher Aufgabe der Erfindung, ein Verfahren der eingangs genannten Art derart weiterzubilden, daß die Qualität der Oberfläche der Löt- und/oder Bondfahnen des auszubildenden Hybridrahmens oder Hybridgehäuses verbessert wird.

Diese Aufgabe wird erfindungsgemäß dadurch gelöst, daß die Löt- und/oder Bondfahnen des Leadframes zum Ausgleich von Oberflächenfehlern zumindest während eines Teils des Spritzvorgangs mittels eines Stempels im Spritzwerkzeug niedergehalten werden.

Ferner wird diese Aufgabe erfindungsgemäß durch das im Anspruch 5 definierte Hybridgehäuse und durch den im Anspruch 6 definierten Hybridrahmen gelöst.

Das erfindungsgemäße Verfahren zeichnet sich dadurch aus, daß durch die erfindungsgemäßen Maßnahmen die Lageposition der einzelnen Löt- und/oder Bondfahnen des Leadframes gut reproduzierbar und eng tolerierbar ist. Das Niederhalten der einzelnen Bondflächen durch den Stempel während des Spritzvorganges bewirkt in vorteilhafter Art und Weise, daß Oberflächenfehler des Leadframes ausgeglichen werden. Außerdem ist von Vorteil, daß durch das Niederhalten der Bondfahnen während des Spritzvorgangs das Schwingungsverhalten der Bondfahnen positiv beeinflußt wird. Die Erfindung besitzt den weiteren Vorteil, daß hierdurch die Bondoberflächen beim Spritzvorgang vor Spritzeinflüßen geschützt sind. Das Niederhalten der Löt- und/oder Bondfahnen des Leadframes während des Spritzvorgangs besitzt den Vorteil, daß hierdurch Lagetoleranzen in einer senkrecht auf die Oberfläche des Leadframes verlaufenden Richtung ausgeglichen werden, so daß auch eine gute Reproduzierbarkeit in dieser z-Achse gegeben ist.

Eine vorteilhafte Weiterbildung der Erfindung sieht vor, daß als Stempel ein Prägestempel verwendet wird. Diese erfindungsgemäße Maßnahme besitzt den Vorteil, daß die dadurch erzeugten Löt- und/oder Bondoberflächen der Löt- und/oder Bondfahnen qualitativ hochwertig sind, insbesondere dann, wenn ein polierter Prägestempel eingesetzt wird. Außerdem wird hiermit erreicht, daß im Bereich der Prägung an allen Positionen der Löt- und/oder Bondfahnen die gleichen Lötund/oder Bondbedingungen vorliegen, so daß der Löt- und/oder Bondprozeß für den Anwender nicht kritisch ist und daher größer toleriert werden kann.

Weitere vorteilhafte Weiterbildungen der Erfindung sind Gegenstand der Unteransprüche.

Weitere Einzelheiten und Vorteile sind dem Ausführungsbeispiel zu entnehmen, das im folgenden anhand der einzigen Figur beschrieben wird. Es zeigt:

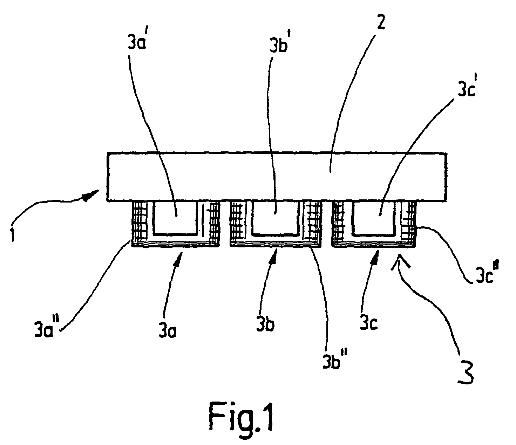

- Figur 1: eine schematische Darstellung eines Hybridgehäuses.

In Figur 1 ist ein Ausführungsbeispiel eines an und für sich bekannten und daher nicht detailliert dargestellten und beschriebenen Hybridgehäuses 1 dargestellt, welches sich im wesentlichen in einen Gehäuseteil 2, der durch das Umspritzen eines Leadframes 3 in einer Spritzform hergestellt wird, und in die aus dem Gehäuseteil 2 hervortretenden Bondfahnen 3a-3c des Leadframes 3 gliedert. Die Bondfahnen 3a-3c weisen jeweils einen geprägten Bereich 3a'-3c' auf, der von einem Haltebereich 3a"-3c" umgeben ist.

Der geprägte Bereich 3a'-3c' ist hierbei derjenige Bereich, auf den beim Spritzvorgang im Spritzwerkzeug ein in der Figur nicht gezeigter Prägestempel aufsetzt, um die Bondfahnen 3a-3c beim Spritzvorgang niederzuhalten.

Es muß an dieser Stelle angeführt werden, daß es zwar bevorzugt wird, daß der die Bondfahnen 3a-3c niederhaltende Stempel als Prägestempel ausgeführt ist, da hierdurch die Bondfahnen 3a-3c beim Spritzprozeß nicht nur positioniert und geschützt werden, sondern gleichzeitig geprägt werden, so daß dieser Prägevorgang kostenneutral ist. Vorzugsweise wird hierbei ein Prägestempel mit einer polierten Oberfläche eingesetzt, was in eine besonders hochwertigen und reproduzierbaren Bondoberfläche resultiert.

Es muß aber betont werden, daß es für die Vielzahl von Anwendungsfällen durchaus ausreichend ist, wenn die Bondfahnen lediglich von einem entsprechenden Stempel niedergehalten werden, d. h., daß kein Prägevorgang stattfindet.

Im vorstehenden Ausführungsbeispiel wird davon ausgegangen, daß es sich hierbei um ein Hybridgehäuse mit Bondfahnen handelt. Hierdurch ist es auch möglich, durch die gleiche Vorgangsweise einen Hybridrahmen mit Bondfahnen auszubilden. Ebenfalls ist es möglich, daß anstelle der Bondfahnen Lötfahnen ausgebildet werden.

Es bedarf daher keinen weiteren Erläuterungen, daß die im Ausführungsbeispiel gezeigte Anzahl von drei Bondfahnen 3a-3c nur beispielhaften Charakter besitzt. Selbstverständlich ist es möglich, weniger oder - was in der Praxis häufiger auftreten wird - mehr als drei Bondfahnen vorzusehen.

## Patentansprüche

1. Verfahren zur Herstellung eines Hybridrahmens oder eines Hybridgehäuses, bei dem ein Leadframe mit Löt- und/ oder Bondfahnen (3a, 3b, 3c) nach dem Einlegen in ein Spritzwerkzeug zur Ausbildung eines Gehäuseteils (2) des Hybridrahmens oder des Hybridgehäuses (1) mit Kunststoff umspritzt wird, **dadurch gekennzeichnet, daß** die Löt- und/oder Bondfahnen (3a-3c) des Leadframes zum Ausgleich von Oberflächenfehlern zumindest während eines Teils des Spritzvorgangs mittels eines Stempels im Spritzwerkzeug niedergehalten werden.

2. Verfahren nach Anspruch 1, **dadurch gekennzeichnet, daß** der Stempel ein Prägestempel ist.

3. Verfahren nach Anspruch 2, **dadurch gekennzeichnet, daß** die Löt- und/oder Bondfahnen (3a-3c) während des Spritzvorgangs geprägt werden.

4. Verfahren nach einem der vorangehenden Ansprüche, **dadurch gekennzeichnet, daß** ein aus einem plattierten Band hergestellter Leadframe (3) verwendet wird.

5. Hybridgehäuse mit einem Gehäuseteil (2) und aus dem Gehäuseteil (2) hervorstehenden Bondfahnen (3a-3c) eines Leadframes (3), **dadurch gekennzeichnet, daß** mindestens eine der Löt- und/oder Bondfahnen (3a-3c) einen durch einen Stempel beaufschlagbaren Prägebereich (3a'-3c') und einen diesen umgebenden Haltebereich (3a"-3c") aufweist.

6. Hybridrahmen, **dadurch gekennzeichnet, daß** mindestens eine der Löt- und/oder Bondfahnen (3a-3c) einen durch einen Stempel beaufschlagbaren Prägebereich (3a'-3c') und einen diesen umgebenden Haltebereich (3a"-3c") aufweist.

## Claims

1. A method for producing a hybrid frame or hybrid housing, in which a leadframe with soldering and/or bonding tags (3a, 3b, 3c) after being placed in an injection moulding die is moulded with plastic to form a housing part (2) of the hybrid frame or the hybrid housing (1), **characterized in that** the soldering and/or bonding tags (3a-3c) of the leadframe are held down in the injection moulding die for the compensation of surface defects at least during a part of the injection moulding process by means of a stamp.

2. The method according to claim 1, **characterized in that** the stamp is a forming stamp.

3. The method according to claim 2, **characterized in that** the soldering and/or bonding tags (3a-3c) are form-stamped during the moulding process.

4. The method according to one of the preceding claims, **characterized in that** a leadframe (3) made from a plated strip is used.

5. A hybrid housing with a housing part (2) and bonding tags (3a-3c) of a leadframe (3) projecting from the housing part (2), **characterized in that** at least one of the soldering and/or bonding tags (3a-3c) has a form-stamping section (3a'-3c'), which can be acted upon by a stamp, and a holding section (3a"-3c") surrounding said form-stamping section (3a'-3c').

6. A hybrid frame, **characterized in that** at least one of the soldering and/or bonding tags (3a-3c) has a form-stamping section (3a'-3c'), which can be acted upon by a stamp, and a holding section (3a"-3c") surrounding said form-stamping section (3a'-3c').

## Revendications

1. Procédé pour la fabrication d'un cadre hybride ou d'un boîtier hybride, dans lequel on recouvre par extrusion avec une substance synthétique une micropoutre comprenant des cosses pour la soudure et/ou pour réaliser le bonding (3a, 3b, 3c), après son insertion dans une machine de moulage par injection pour la réalisation d'un élément de boîtier (2) du cadre hybride ou du boîtier hybride (1), **caractérisé en ce qu'**on contient les cosses de la micropoutre pour la soudure et/ou pour réaliser le bonding (3a - 3c) pour supprimer les inégalités superficielles, au moins pendant une partie du processus de moulage par injection, à l'aide d'un poinçon dans la machine de moulage par injection.

2. Procédé selon la revendication 1, **caractérisé en ce que** le poinçon est un poinçon d'emboutissage sur presse.

3. Procédé selon la revendication 2, **caractérisé en ce qu'**on soumet les cosses pour la soudure et/ou pour réaliser le bonding (3a - 3c) à un emboutissage au cours du processus de moulage par injection.

4. Procédé selon l'une quelconque des revendications précédentes, **caractérisé en ce qu'**on utilise une micropoutre (3) fabriquée à partir d'un ruban plaqué.

5. Boîtier hybride comportant un élément de boîtier (2) et des cosses pour réaliser le bonding (3a - 3c) d'une micropoutre (3) faisant saillie par rapport à l'élément de boîtier (2), **caractérisé en ce qu'**au moins une des cosses pour la soudure et/ou pour réaliser le bonding (3a - 3c) présente une zone d'emboutissage (3a' - 3c') apte à être sollicitée par un poinçon et une zone de retenue (3a" - 3c") entourant la première citée.

6. Cadre hybride, **caractérisé en ce qu'**au moins une des cosses pour la soudure et/ou pour réaliser le bonding (3a - 3c) présente une zone d'emboutissage (3a' - 3c') apte à être sollicitée par un poinçon et une zone de retenue (3a" - 3c") entourant la première citée.
